Europäisches Patentamt

European Patent Office

Office européen des brevets

(11) Publication number: **0 388 552**
**A2**

# EUROPEAN PATENT APPLICATION

(21) Application number: **89309406.0**

(22) Date of filing: **15.09.89**

(51) Int. Cl.⁵: **H03G 3/20**

(30) Priority: **18.03.89 JP 67328/89**

(43) Date of publication of application:
**26.09.90 Bulletin 90/39**

(84) Designated Contracting States:
**DE GB**

(71) Applicant: **PIONEER ELECTRONIC
CORPORATION
No. 4-1, Meguro 1-chome
Meguro-ku Tokyo 153(JP)**

(72) Inventor: **Kosuga, Tadashi Pioneer Electronic
Corporation
Kawagoe Works No 25-1 Aza Nishi-machi
Ohaza Yamada
Kawagoe-shi Saitama(JP)**

(74) Representative: **Sturt, Clifford Mark et al
MARKS & CLERK 57-60 Lincoln's Inn Fields
London WC2A 3LS(GB)**

(54) **Receiver.**

(57) A receiver in which a filter (9) is inserted at the front stage of an AGC amplifying circuit (8) for setting an attenuation amount of a received RF signal on the basis of an ouput of a mixing circuit (4), thereby eliminating the local frequency signal component from the output of the mixing circuit (4) so that the sensitivity of the receiver can be kept even if the local frequency signal has a relatively high level.

Fig. 4

EP 0 388 552 A2

The present invention relates to a receiver having a wide band AGC (automatic gain control) function.

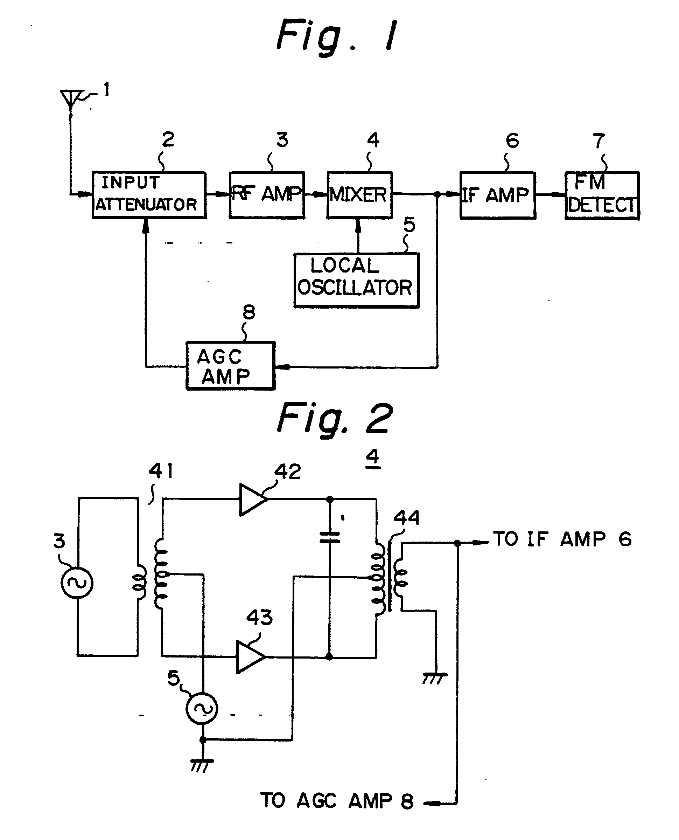

An example of a conventional receiver having the wide band AGC function will be described with reference to Fig. 1.

In Fig. 1, a received radio frequency (hereinafter, referred to as an RF) signal supplied from an antenna 1 is attenuated to a proper level through an input attenuating circuit 2 whose attenuation amount is determined on the basis of a level of an AGC signal which is supplied from an AGC amplifying circuit 8 and, thereafter, the RF signal is supplied to an RF amplifying circuit 3. The RF amplifying circuit 3 amplifies the RF signal and supplies to one input terminal of a mixing circuit 4. A local frequency signal of a frequency corresponding to a tuned frequency is supplied from a local oscillating circuit 5 to the other input terminal of the mixing circuit 4. The mixing circuit 4 obtains the sum or difference signal of the RF signal and the local frequency signal and supplies it as an intermediate frequency (hereinafter, referred to as an IF) signal to an IF amplifying circuit 6 and to the AGC amplifying circuit 8.

An example of a construction of the mixing circuit 4 is shown in Fig. 2. Fig. 2 shows an example of the mixing circuit using such a balanced mixer as disclosed in U.S.P. 4,449,245. The mixing circuit 4 comprises: an input transformer 41 in which a center tap of a secondary winding is connected to the ground through the local oscillating signal source 5; a switching element 42 to which an in-phase output of the input transformer 41 is supplied; a switching element 43 to which a inverse phase output of the input transformer 41 is supplied; and an output transformer (IF transformer) 44. Outputs of the switching elements 42 and 43 are respectively supplied to both ends to a primary winding of the output transformer. The primary winding is provided with a center tap which is connected to the ground. A capacitor C is connected between input terminals of the output transformer 44 so as to form an IF tuning circuit. The switching elements 42 and 43 may be, for example, an FET with the gate thereof grounded and are designed to be conductive when the amplitude of the input signal thereto exceeds a predetermined amplitude.

When, with the above circuit arrangement, an RF signal is supplied from the RF amplifying circuit 3 to the primary winding of the input transformer 41, in-phase and inverse phase signals corresponding to the RF signal with a phase difference of 180° are obtained across the secondary winding of the input transformer 41 and are respectively supplied to the switching elements 42 and 43. On the other hand, in-phase local oscillating signals are supplied to the switching elements 42 and 43 through the center tap of the transformer 41, respectively. Each of the switching elements 42 and 43 amplifies the two input signals and relays those signals to both ends of the primary winding of the output transformer 44. Since the components of the local oscillating signals which are fed from the switching elements are in-phase to each other, they are cancelled in the primary winding of the output transformer 44 and do not appear across the secondary winding of the output transformer 44.

On the other hand, the signal of the frequency corresponding to the frequency difference between the RF signal frequency and the local frequency relayed by the switching elements, that is, the IF signal is inverse in phase to each other. Therefore, they are added to each other in the primary winding of the output transformer 44 and the added signal is taken out as the IF signal from the secondary winding of the transformer 44. The other frequency components are suppressed by the IF tuning circuit.

The IF amplifying circuit 6 is a narrow band amplifier to amplify only the IF signal. The IF signal amplified by the IF amplifying circuit 6 is, for instance, detected by a detector 7 such as an FM detector and is demodulated to stereo composite signals which are supplied to stereo demodulating state (not shown) thereby to produce right and left channel signals.

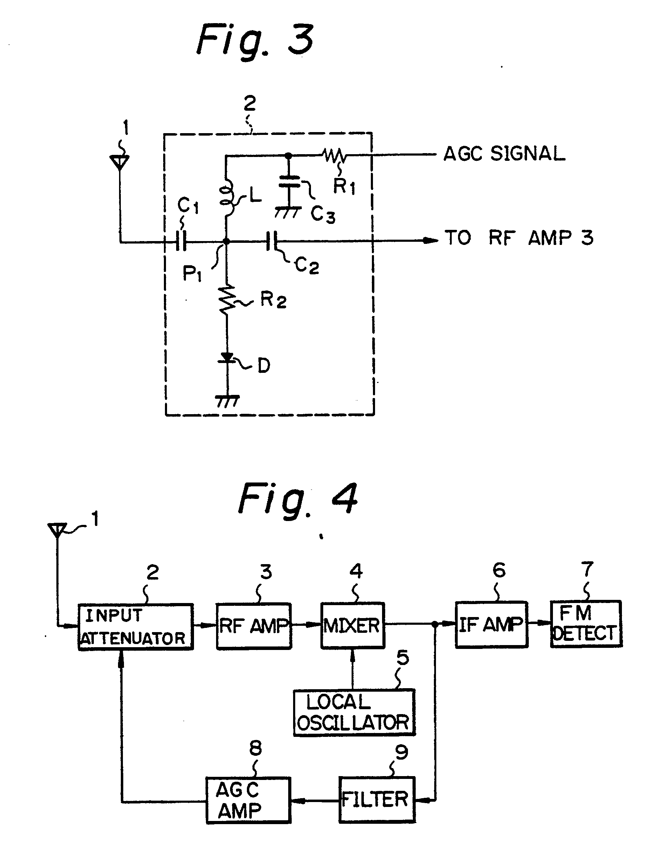

On the other hand, the AGC amplifying circuit 8 supplied to the input attenuating circuit 2 an AGC signal which has been obtained by amplifying, detecting, and smoothing the IF signal. An example of a construction of the input attenuating circuit 2 is shown in Fig. 3.

In Fig. 3, the AGC signal passes through a time constant circuit comprising a resistor R1 and a capacitor C3 and is supplied to one end of a series circuit which is constructed by serially connecting a choke coil L, a resistor R2, and a diode D for blocking the passage of the RF signal. The other end of the series circuit is connected to the ground. The RF signal supplied from the antenna 1 passes through a coupling capacitor C1, a connecting point P1 between the choke coil L and the resistor R2, and a coupling capacitor C2 and is supplied to the RF amplifying circuit 3.

The circuits 2, 3, 4, and 8 form a wide band AGC loop.

When, in the above construction, the level of the RF signal and/or the level of jamming signal with a frequency close to the RF signal increases, the level of the IF signal which is fed from the mixing circuit 4 rises. The AGC amplifying circuit 8 supplied the AGC signal of the level corresponding to the IF signal level to the input attenuating circuit 2. The diode D of the input attenuating circuit 2 is turned off when the AGC signal level is low, so that the input RF signal is directly supplied to the RF amplifying circuit 3 without being attenuated.

When the AGC signal level increases and exceeds a predetermined level, the diode D is turned on and the resistor $R_2$ is inserted between the reception RF signal path and the ground. Thus, the RF signal is bypassed and the level of the RF signal which is to be supplied to the RF amplifying circuit 3 is suppressed.

When the wide band AGC circuit so constructed as mentioned above is used, the mutual modulation which is caused due to the existence of the jamming wave signal of the frequency near the RF signal in the middle strong electric field is prevented and a radio interference phenomenon can be reduced.

However, there is such a phenomenon that the wide band AGC circuit operates and reduces the receiving sensitivity of the receiver even if circuit operates and reduces the receiving sensitivity of the receiver.

Through some experiments, it has been revealed that when the local oscillator 5 is designed to produce a high level, such as 120 dB, of the local frequency signal in order to avoid the so-called inter-modulation even in the face of strong input RF signals a local frequency signal component or its harmonic component leaks into the IF signal with the result that the AGC circuit operates even when the RF signal level is low.

Even though an ideal balanced mixer does not relay the local frequency signal component, an existing balanced mixer produces at its output the local frequency signal component of a level within about a range from 20 to 30 [dB] lower than the level of the original local frequency signal. When, therefore, the output level of the local oscillator 5 increases to some extent, or the balanced mixer 4 is poor in balance, the AGC amplifying circuit 8 has too much high sensitivity, the local frequency signal component which leaked into the IF signal causes an erroneous operation of the AGC circuit.

It is, therefore, an object of the invention to provide a receiver with a wide band AGC circuit which is substantially free from erroneous operation.

To accomplish the above object, there is provided a receiver comprising: an attenuator to attenuate an input signal; a radio frequency amplifying circuit to amplify a radio frequency signal supplied thereto through the attenuator; a mixing circuit for mixing a output signal of the radio frequency amplifying circuit and a local frequency signal so as to obtain an intermediate frequency signal; and an AGC circuit to control an attenuation amount of the attenuator on the basis of the level of the intermediate frequency signal, wherein the AGC circuit has filter means for suppressing the level of the local frequency signal component appearing in the output signal of the mixer.

An embodiment of the invention will now be described by way of example only and with reference to the accompanying drawings. in which :-

Fig. 1 is a block diagram showing a prior art receiver;

Fig. 2 is a circuit diagram showing an example of a mixing circuit in the receiver of Fig. 1;

Fig. 3 is a circuit diagram showing an example of an input attenuator in the receiver of Fig. 1; and

Fig. 4 is a block diagram showing an embodiment of the present invention.

An embodiment of the present invention will be described hereinbelow with reference to Fig. 4. In a receiver shown in Fig. 4, the parts and elements corresponding to those of the receiver shown in Fig. 1 are designated by the same reference numerals and explanations thereof is omitted.

In the receiver shown in Fig. 4, an IF signal output of the mixing circuit 4 is supplied to the AGC amplifying circuit 8 through a filter circuit 9. The filter circuit 9 may be a low pass filter, band pass filter, or the like and blocks a local frequency but passes there through the intermediate frequency. The other constructions are similar to those in the receiver shown in Fig. 2.

The operation of the receiver of Fig. 4 will now be described. The received RF signal from the antenna 1 is transmitted through the input attenuating circuit 2 and is amplified by the RF amplifying circuit 3. The amplified RF signal and the local frequency signal from the local oscillator 5 are mixed with each other by the mixing circuit 4. The IF signal, RF signal, local frequency signal, their harmonic components, and so on are included in the output of the mixing circuit 4. When, as mentioned above, the output level of the local oscillator 5 is high, the local frequency signal component which has leaked into the output signal of the mixing circuit 4 is higher in level than the IF signal. However, the filter circuit 9 eliminates the local frequency signal component from the output of the mixing circuit and supplies the resultant output signal to the AGC amplifying circuit 8.

The AGC amplifying circuit 8 obtains the AGC signal by amplifying, detecting, and smoothing the output of the filter circuit 9 from which the noise component resulted from the high level of the local frequency signal is neglected. Then, the AGC amplifying circuit 8 supplies the AGC signal to the input attenuator 2, thereby adjusting an attenuation amount of the input attenuator.

Even when, therefore, the level of the IF signal which is fed from the mixing circuit 4 is larger than a predetermined value or when the amount of the jamming wave signal component caused in the IF signal is larger than a predetermined value, the wide band AGC circuit more accurately operates so as to increase the attenuation amount of the input attenuator 2. The amplitude of the RF signal which is supplied to the RF amplifying circuit 3 is decreased. The occurrence of the unwanted interference is reduced. On the other hand, there is an advantage such that it is also possible to use a mixing circuit of the relatively cheap circuit construction because of the local frequency noise eliminating function by the filter circuit 9.

The RF amplifying circuit 3 can be replaced to both of an antenna tuning circuit and an RF tuning amplifying circuit. On the other hand, it is also possible to add the so-called narrow band AGC in which the gain of the RF amplifying circuit 3 is controlled by a demodulation signal appearing at a stage succeeding to the IF amplifying circuit 6.

As described above, in the receiver of the invention, the filter is inserted at the front stage of the AGC amplifying circuit to set the attenuation amount of the received RF signal on the basis of the output of the mixing circuit, thereby eliminating the local frequency signal component from the output of the mixing circuit. Therefore, the sensitivity of the receiver can be kept even if frequency signal has a high level.

## Claims

1) A receiver comprising:
an attenuator for attenuating an input signal;
a radio frequency amplifying circuit for amplifying a radio frequency signal transmitted through said attenuator;
a mixing circuit for mixing the radio frequency signal amplified by said radio frequency amplifying circuit and a local frequency signal so as to produce an intermediate frequency signal; and
an AGC circuit for controlling an attenuation amount of said attenuator on the basis of a level of said intermediate frequency signal,
wherein said AGC circuit has filter means for suppressing a level of the local frequency signal component contained in said intermediate frequency signal.

2) A receiver according to claim 1, in which said mixing circuit includes a superposing means for superposing said local frequency on the amplified radio frequency signal, switching means for passing there through the amplified radio frequency signal when an amplitude of the amplified radio frequency signal exceeds an predetermined amplitude, and filter means for extracting said intermediate frequency signal from an output signal from said switching means.

Nouvellement déposé

# Fig. 1

# Fig. 2

TO IF AMP 6

TO AGC AMP 8

# Fig. 3

AGC SIGNAL

TO RF AMP 3

# Fig. 4